# EUROPEAN PATENT APPLICATION

(11) **EP 4 679 950 A1**
(43) Date of publication of application: **14.01.2026**
(21) Application number: 25183208.5
(22) Date of filing: 17.06.2025
(51) Int. Cl.: H05K 7/14, H05K 7/20

(54) **LIQUID COOLING APPARATUS AND LIQUID-COOLED CONTAINER**

(30) Priority: 18.06.2024 CN 202421399075 U
(71) Applicant: Straitdeer Pte. Ltd., Singapore 339509 (SG)
(72) Inventor: LIAO, WANG, 339509 Singapore (SG); LIANG, CHAO, 339509 Singapore (SG); LIU, HAIQUAN, 339509 Singapore (SG); YANG, QINGYAN, 339509 Singapore (SG); WANG, JIAN, 339509 Singapore (SG); XIA, YU, 339509 Singapore (SG); REN, GUIHONG, 339509 Singapore (SG)
(74) Representative: Metida

(57) **Abstract**

Disclosed are a liquid cooling apparatus and a liquid-cooled container. The liquid cooling apparatus includes a liquid cooling cabinet, a server, and a power distribution unit. The liquid cooling cabinet includes a first side panel, a top plate, a second side panel, and a base plate that are sequentially connected to form a rectangular frame. A first rack is secured within the rectangular frame, wherein the first rack includes a first rack body and a second rack body. The first rack body is abutted against an inner wall of the first side panel, and the second rack body is spaced apart from the second side panel. A plurality of first mounting positions for accommodating the servers are arranged on the first rack in a vertical direction.

## Description

### TECHNICAL FIELD

The present disclosure relates to the technical field of data processing, and in particular, relates to a liquid cooling apparatus and a liquid-cooled container.

### BACKGROUND

With the rise and development of industries such as Internet virtual assets and artificial intelligence, the demands on data processing capabilities of data processing devices are becoming increasingly stringent. To enhance the computing power of the data processing devices, the scale of hardware infrastructure thereof is continuously expanding, operating time is being prolonged, and thus power consumption is increasing. Consequently, when the data processing devices operate for extended periods, the operating temperature gradually rises. This leads to accelerated aging of hardware components and an increased rate of malfunctions.

To reduce the operating temperature of the data processing devices, cooling systems are typically employed. Common cooling solutions include liquid cooling (or water cooling) systems. In the related arts, it is a common practice to stack a large number of data processing devices and power supply devices sequentially within a chassis. During operation, these devices collectively generate a concentrated amount of heat, leading to very high temperatures inside the chassis. Internally, the data processing devices are provided with flow channel plates (or cold plates with flow channels) through which water circulate. Water from the liquid cooling system is supplied to these flow channel plates to carry away the heat generated within the data processing device, with the aim of reducing the temperature inside the chassis. However, because rows of chassis are typically arranged close to each other, this means that the data processing devices are stacked or densely packed in both vertical and horizontal directions. As a result, the devices are distributed at a high density, and the cooling effect achieved by the water cooling system often fails to meet user expectations.

### SUMMARY

In view of the above, the present disclosure is mainly intended to provide a liquid cooling apparatus and a liquid-cooled container that achieve a better heat dissipation effect.

To achieve the above objective, the present disclosure employs the following technical solutions:

Some embodiments of the present disclosure provide a liquid cooling apparatus. The liquid cooling apparatus includes a liquid cooling cabinet, a server, and a power distribution unit; wherein a number of series-connected chips within the server is greater than one hundred; and the liquid cooling cabinet includes a first side panel, a top plate, a second side panel, and a base plate that are sequentially connected to form a rectangular frame, wherein the first side panel and the second side panel are arranged opposite to each other in a first horizontal direction, the top plate and the base plate are disposed opposite to each other in a vertical direction, and the rectangular frame is open in a second horizontal direction, the first horizontal direction being perpendicular to the second horizontal direction;
wherein a first rack is secured within the rectangular frame, the first rack including first rack body and a second rack body, wherein the first rack body and the second rack body are arranged along the first horizontal direction, the first rack body is abutted against an inner wall of the first side panel, the second rack body is spaced apart from the second side panel, the first rack body and the second rack body cooperate to form the first rack, and a plurality of first mounting positions for accommodating the servers are arranged on the first rack in the vertical direction; and
wherein a second rack is further secured within the rectangular frame, a plurality of second mounting positions for accommodating the power distribution units being arranged on the second rack in the vertical direction; and one end of the second rack is secured to the second rack body, and another end of the second rack is abutted against an inner wall of the second side panel.

In some embodiments, a third mounting position is arranged above the first mounting position, wherein the third mounting position is spaced apart from the top plate;
the liquid cooling apparatus further includes a network switch, wherein the network switch is accommodated in the third mounting position; and
a cable routing hole is arranged in the top plate.

In some embodiments, in the vertical direction, a spacing is defined between adjacent first mounting positions; and/or
a spacing is defined between adjacent second mounting positions; and/or
a spacing is defined between the first mounting position and the third mounting position.

In some embodiments, each of the first rack body and the second rack body includes a main body and a plurality of support plates spaced apart along the vertical direction, the support plates being connected to the main body;
wherein the support plates on the first rack body and the support plates on the second rack body at a same height cooperate to form the first mounting position, and opposite ends of the server are configured to rest on the support plates; and
wherein the main body includes a first rod and a second rod that extend along the vertical direction, wherein the first rod is parallel to the second rod, the first rod and the second rod are both securely connected to the rectangular frame, one end of each of the support plates is connected to the first rod, and another end of the support plate is connected to the second rod.

In some embodiments, the second rack includes a plurality of first securing rods spaced apart along the vertical direction, a plurality of second securing rods spaced apart along the vertical direction, and at least two mutually parallel connecting rods connected between the first securing rod and the second securing rod at a same height.

In some embodiments, the server includes opposite first and second ends; wherein a power supply and/or communication interface is arranged at the first end, a liquid inlet connector and a liquid outlet connector are arranged at the second end, and a liquid flow plate in communication with both the liquid inlet connector and the liquid outlet connector is arranged inside the server;
a plurality of the liquid cooling cabinets are provided, and the liquid cooling cabinets are closely arranged along the first horizontal direction to form a liquid cooling cabinet group;
in the second horizontal direction, each of the liquid cooling cabinets includes opposite first and second sides, and the liquid cooling cabinet, on the first side, comprises a first manifold arranged close to the first rack body and a second manifold arranged close to the second rack body, wherein the liquid inlet connector is connected to the first manifold, and the liquid outlet connector is connected to the second manifold; and
the liquid cooling apparatus further includes a water inlet pipe and an water outlet pipe, and a liquid path control device connected to the water inlet pipe and/or the water outlet pipe to control water flow, wherein the water inlet pipe is in communication with the first manifold, and the water outlet pipe is in communication with the second manifold;
wherein the liquid path control device and the liquid cooling cabinet group are disposed within a same space, or a separating plate is disposed therebetween to separate the liquid path control device and the liquid cooling cabinet group into different spaces.

In some embodiments, a drip tray is arranged at the second end, the drip tray being disposed below the liquid inlet connector and the liquid outlet connector;
wherein the server includes an outer shell, wherein the drip tray is integrally formed with the outer shell.

In some embodiments, a cable routing hole is arranged in the top plate corresponding to the second rack; and
the liquid cooling cabinet, on the second side, includes a cable management column arranged close to the first rack body;
wherein the cable management column, in the first horizontal direction or the second horizontal direction, includes a first part and a second part that are engageable with each other, a plurality of notches for cables to be inserted therein being arranged in the second part.

In some embodiments, the liquid cooling apparatus further includes a power distribution cabinet, the power distribution unit drawing power from the power distribution cabinet;
wherein in the first horizontal direction, the power distribution cabinet is arranged at one end of the liquid cooling cabinet group, and the liquid path control device is arranged at another end of the liquid cooling cabinet group.

Some embodiments of the present disclosure further provide a liquid-cooled container. The liquid-cooled container includes an enclosure and the liquid cooling apparatus as described above, wherein the liquid cooling apparatus is at least partially accommodated within the enclosure.

The liquid cooling apparatus and the liquid-cooled container according to the present disclosure enhance air convection within the liquid cooling cabinets by incorporating first racks and second racks therein, thereby facilitating the dissipation of heat from the servers. Secondly, the first racks for accommodating servers and the second racks for accommodating power distribution units are arranged along the first horizontal direction. Consequently, a spacing between servers in adjacent liquid cooling cabinets is relatively large, leading to a smaller distribution density and reducing the likelihood of heat concentration. Furthermore, the first racks and the second racks are in communication in the first horizontal direction. This configuration increases air convection between their respective spaces, further promoting the dissipation of heat from the servers.

Other beneficial effects of the present disclosure are described in retail with reference to specific technical features and technical solutions in the specific embodiments. A person skilled in the art may understand the beneficial effects achieved by these technical features and technical solutions through description of these technical features and technical solutions.

### BRIEF DESCRIPTION OF THE DRAWINGS

Some embodiments of the present disclosure are described with reference to accompanying drawings hereinafter.
FIG. 1 and FIG. 2 are a schematic perspective view and a schematic front view of a liquid cooling apparatus according to the present disclosure;
FIG. 3 and FIG. 4 are schematic perspective views, taken from different angles, of a server in a liquid cooling apparatus according to the present disclosure;
FIG. 5 to FIG. 9 are schematic perspective views, taken from different angles, of a liquid-cooling cabinet of a liquid cooling apparatus according to the present disclosure;
FIG. 10 is a schematic cross-sectional view of a cable management column of a liquid cooling cabinet in a liquid cooling apparatus according to the present disclosure; and
FIG. 11 and FIG. 12 are schematic perspective views, taken from different angles, of a liquid-cooled container according to the present disclosure.

Reference numerals and denotations thereof: 1-liquid-cooled container; 2121-enclosure; 211-first space; 212-second space; 10-liquid cooling apparatus; 11-data processing system; 111-server; 111a-first end; 1111-power supply and/or communication interface; 111b-second end; 1112-liquid inlet connector; 1113-liquid outlet connector; 1114-drip tray; 1110-outer shell; 112-network switch; 12-liquid cooling cabinet; 1211-first side panel; 1212-second side panel; 1213-top plate; 1215-cable routing hole; 1214-base plate; 12a-first side; 122a-first manifold; 122b-second manifold; 12b-second side; 123-cable management column; 123a-first part; 123b-second part; 124-first rack 1240-first mounting position; 1241-first rack body; 1243-main body; 1246-first rod; 1247-second rod; 1245-support plate; 1242-second rack body; 125-second rack; 1250-second mounting position; 1251-first securing rod; 1252-second securing rod; 1253-connecting rod; 1254-third mounting position; 127-water inlet pipe; 128-water outlet pipe; 129-liquid path control device; 1291-separating plate; 13-power supply system; 131-power distribution cabinet; 132-power distribution unit.

### DETAILED DESCRIPTION

The present disclosure is described with reference to some exemplary embodiments. However, the present disclosure is not limited to these exemplary embodiments. In the detailed description of the present disclosure, specific details are set forth. To avoid unnecessarily obscuring the substance of the present disclosure, well-known methods, procedures, processes, and components have not been described in detail.

Furthermore, it should be understood by persons of ordinary skill in the art that the drawings provided herein are for illustrative purposes only and are not necessarily drawn to scale.

Unless the context clearly requires otherwise, throughout this specification and the claims, the words "comprise," "contain," and the like are to be construed in an inclusive sense, as opposed to an exclusive or exhaustive sense, that is, in the sense of "including, but not limited to."

It should be noted that terms such as "first," "second," and the like are merely used for illustration purpose during the description of the present disclosure, and shall not be understood as indicating or implying relative importance. In addition, in the description of the present disclosure, the term "multiple," "more," or "a plurality of" refers to at least two unless otherwise specified.

Some embodiments of the present disclosure provide a liquid cooling apparatus. The liquid cooling apparatus includes a liquid cooling cabinet, a server, and a power distribution unit. The liquid cooling cabinet includes a first side panel, a top plate, a second side panel, and a base plate that are sequentially connected to form a rectangular frame. The first side panel and the second side panel are arranged opposite to each other in a first horizontal direction, the top plate and the base plate are arranged opposite to each other in a vertical direction, and the rectangular frame is open in a second horizontal direction. The first horizontal direction is perpendicular to the second horizontal direction.

A first rack is secured within the rectangular frame, wherein the first rack includes a first rack body and a second rack body. The first rack body and the second rack body are arranged along the first horizontal direction. The first rack body is abutted against an inner wall of the first side panel, and the second rack body is spaced apart from the second side panel. The first rack body and the second rack body cooperate to form the first rack. A plurality of first mounting positions for accommodating the servers are arranged on the first rack in the vertical direction; and

A second rack is further secured within the rectangular frame, wherein a plurality of second mounting positions for accommodating the power distribution units are arranged on the second rack in the vertical direction. One end of the second rack is secured to the second rack body, and another end of the second rack is abutted against an inner wall of the second side panel.

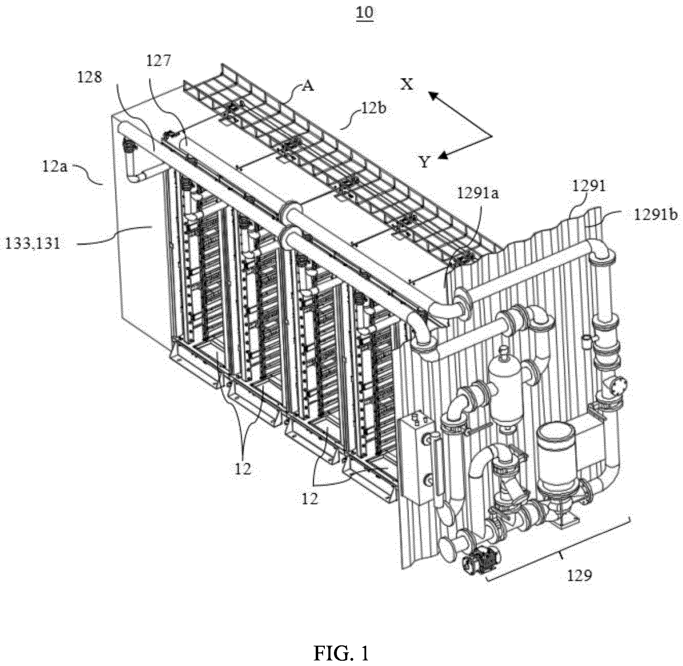

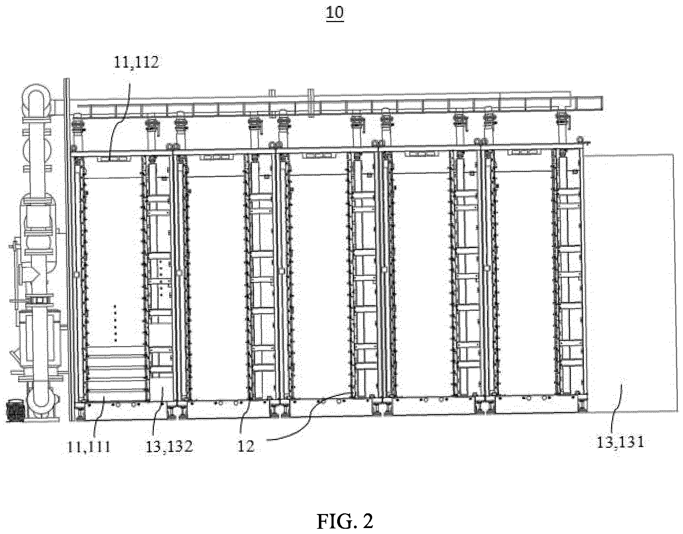

Referring to FIG. 1 and FIG. 2, a liquid cooling apparatus 10 according to the present disclosure includes a data processing system 11, a liquid cooling cabinet 12, and a power supply system 13. The power supply system 13 supplies power to the data processing system 11. In some embodiments, the power supply system 13 also supplies power for the operation of the liquid cooling cabinet 12.

In some embodiments, the power supply system 13 includes a power distribution cabinet 131 and power distribution units 132 (FIG. 2 schematically illustrates only the power distribution cabinet 131 and some of the power distribution units 132). The power distribution cabinet 131 is connected to an external power source to supply electrical energy. The power distribution units 132 are electrically connected to the power distribution cabinet 131, facilitating the supply of electrical energy to the data processing system 11. At least some devices within the data processing system 11 may draw power from the power distribution units 132, rather than being directly connected via cables to the power distribution cabinet 131 to draw power. In some embodiments, some devices within the data processing system 11 may also draw power directly from the power distribution cabinet 131, with no need of drawing power through the power distribution units 132.

The data processing system 11 includes a server 111 and a network switch 112. The server 111 is connected to the network switch 112 via a cable. Signals supplied by the network switch 112 to the server 111 include, but are not limited to, network signals. In the embodiments, the data processing system 11 includes a plurality of servers 111, and at least one network switch 112. It is to be understood that the numbers of servers 111 and network switches 112 are not limited and may be adjusted according to the data processing needs of the liquid cooling apparatus 10. In some embodiments, the server 111 includes at least one hash board (i.e., computing board, not illustrated), with hundreds or even thousands of chips arranged thereon. The number of chips that are connected in series is greater than one hundred. It is to be understood that the number of chips on the hash board may be adjusted according to actual needs of computing power.

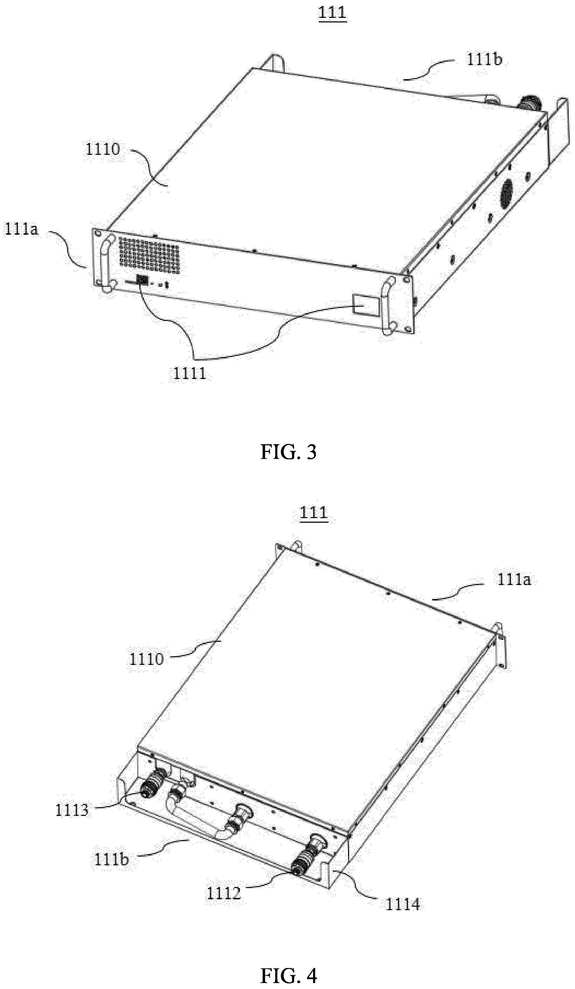

Referring to FIG. 3 and FIG. 4, in some embodiments, the server 111 includes a first end 111a and a second end 111b that are opposite to each other. A power supply and/or communication interface 1111 is arranged at the first end 111a. The server 111 includes an outer shell 1110. A liquid inlet connector 1112 and a liquid outlet connector 1113 are arranged at the second end 111b. A liquid flow plate (cold plate or flow distribution plate) that is in communication with a casing of the liquid inlet connector 1112 and with the liquid outlet connector 1113 is arranged inside the server 111.

In some embodiments, a drip tray 1114 is arranged at the second end 111b of the server 111. The drip tray 1114 is disposed beneath the liquid inlet connector 1112 and the liquid outlet connector 1113. The server 111 includes the outer shell 1110, and the drip tray 1114 is integrally formed with the outer shell 1110. Where the liquid inlet connector 1112 and the liquid outlet connector 1113 leak, the drip tray 1114 may collect the water, thereby preventing water droplets from splashing and affecting the operation of the servers 111 within the entire liquid cooling cabinet 12. In some embodiments, a drainage structure, such as a drainage hole, may be arranged at the bottom of the drip tray 1114 to facilitate directional discharge of water. Furthermore, the drip tray 1114 may also protect the liquid inlet connector 1112 and the liquid outlet connector 1113, such that the liquid inlet connector 1112 and the liquid outlet connector 1113 are prevented from being bumped into and consequently damaged during processes such as installation and transportation.

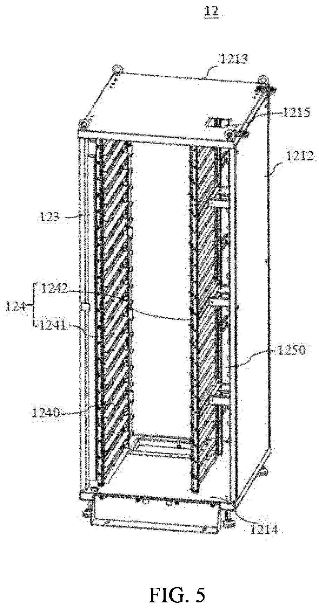

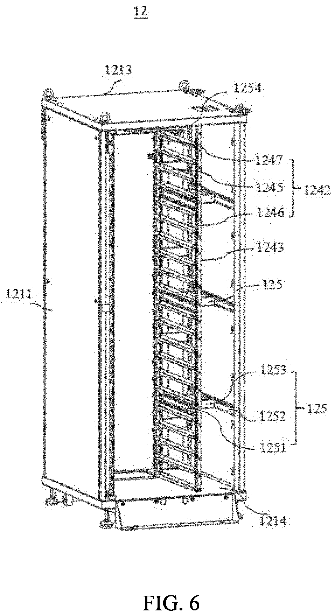

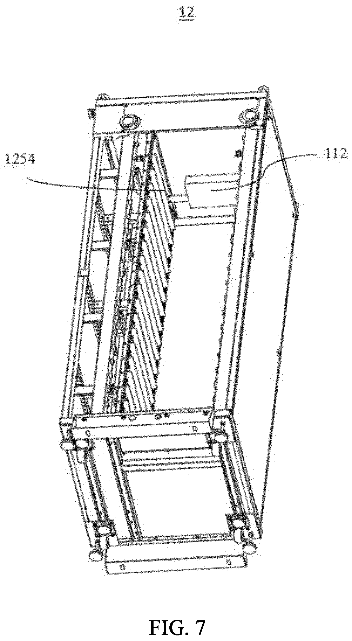

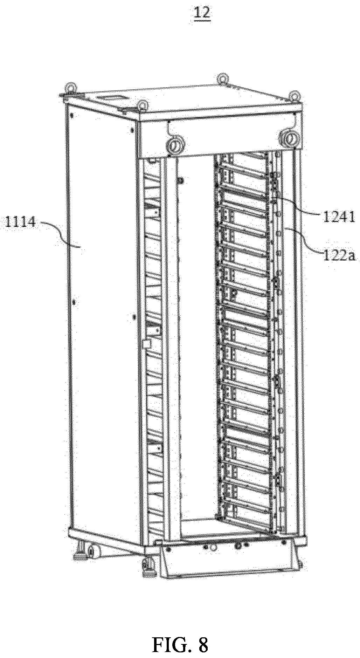

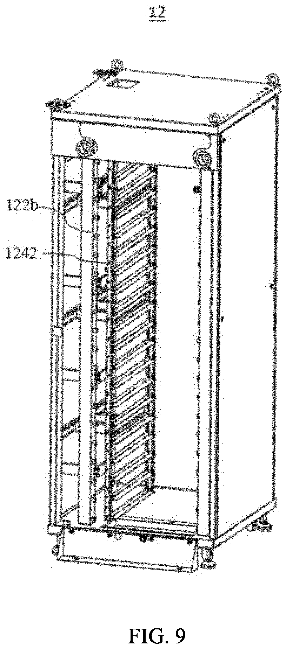

Referring to FIG. 1, FIG. 2, and FIG. 5 to FIG. 9, a plurality of liquid cooling cabinets 12 are provided, which are closely arranged along a first horizontal direction (X-direction) to form a liquid cooling cabinet group. It is to be understood that the close arrangement of the liquid cooling cabinets 12 means that outer side walls of adjacent liquid cooling cabinets 12 are abutted against each other, or gaps between the cabinets are very small, such that these cabinets tend to be in an abutting state. The plurality of liquid cooling cabinets 12 within the liquid cooling cabinet group have an identical structure. The structure of one such liquid cooling cabinet 12 is described hereinafter as an example.

In some embodiments, the liquid cooling cabinet 12 includes a first side panel 1211, a second side panel 1212, a top plate 1213, and a base plate 1214. The first side panel 1211 and the second side panel 1212 are arranged opposite to each other in the first horizontal direction, and the top plate 1213 and the base plate 1214 are arranged opposite to each other in a vertical direction. The first side panel 1211, the second side panel 1212, the top plate 1213, and the base plate 1214 are sequentially connected to form a rectangular frame. The rectangular frame has an open structure in a second horizontal direction (Y-direction). The first horizontal direction is perpendicular to the second horizontal direction.

Within the internal space of the liquid cooling cabinet 12, a first rack 124 and a second rack 125 are securely mounted. The first rack 124 and the second rack 125 are securely connected to each other. The first rack 124 is used, at least in part, for accommodating the servers 111, and the second rack 125 is used for accommodating the power distribution units 132.

It is to be understood that the first rack 124 and the second rack 125 are secured within the liquid cooling cabinet 12. Specifically, at least some components of the first rack 124 and/or the second rack 125 may be connected to the first side panel 1211, and/or the second side panel 1212, and/or the top plate 1213, and/or the base plate 1214, provided that the first rack 124 and the second rack 125 are reliably secured within the rectangular frame.

In some embodiments, the first rack 124 specifically includes a first rack body 1241 and a second rack body 1242 that are arranged along the first horizontal direction. The first rack body 1241 is arranged closely against (or abutted against) an inner wall of the first side panel 1211, and the second rack body 1242 is spaced apart from the second side panel 1212. The first rack body 1241 and the second rack body 1242 cooperate to form the first rack 124. First mounting positions 1240 for accommodating a plurality of servers 111 are arranged on the first rack 124 in the vertical direction.

In some embodiments, the first rack body 1241 and the second rack body 1242 are structurally identical. Each of the first rack body 1241 and the second rack body 1242 includes a main body 1243 and support plates 1245 spaced apart in the vertical direction. The support plates 1245 are securely connected to the main body 1243. A support plate 1245 on the first rack body 1241 and a support plate 1245 on the second rack body 1242, disposed at the same height, cooperate to form a first mounting position 1240. Two opposite ends of the server 111 (other than the first end 111a and the second end 111b) may rest on (or be supported by) the support plates 1245.

In some embodiments, the main body 1243 includes a first rod 1246 and a second rod 1247 that extend in the vertical direction. The first rod 1246 and the second rod 1247 are parallel to each other, and both the first rod 1246 and the second rod 1247 are securely connected to the rectangular frame. The support plate 1245 extends in the second horizontal direction, with one end thereof connected to the first rod 1246 and the other end thereof connected to the second rod 1247. The first rack 124 as a whole has an openwork structure. The area of the first rack 124 that obstructs air convection is reduced, which helps to improve the heat dissipation performance of the liquid cooling cabinet 12.

In some embodiments, a second rack 125 is further arranged within the rectangular frame. A plurality of second mounting positions 1250 for accommodating the power distribution units 132 are arranged on the second rack 125 in the vertical direction; and one end of the second rack 125 is secured to the second rack body 1242, and another end of the second rack 125 is abutted against an inner wall of the second side panel 1212.

In some embodiments, the second rack 125 includes a plurality of first securing rods 1251 spaced apart along the vertical direction, a plurality of second securing rods 1252 spaced apart along the vertical direction, and at least two mutually parallel connecting rods 1253 connected between the first securing rod 1251 and the second securing rod 1252 at a same height. The second rack 125 as a whole has an openwork structure. The area of the second rack 125 that obstructs air convection is reduced, which helps to improve the heat dissipation performance of the liquid cooling cabinet 12.

It is to be understood that the first rack body 1241, the second rack body 1242, and the second rack 125 are all 'rack' structures; that is, they are not formed from complete plate-like components but possess an openwork structure. In this way, air convection within the liquid cooling cabinet 12 may be enhanced, which helps to dissipate the heat from the servers 111. It is to be understood that the specific structures of the first rack body 1241, the second rack body 1242, and the second rack 125 are not limited, as long as it is ensured that the first rack body 1241, the second rack body 1242, and the second rack 125 exhibit a "rack" structure (or maintain a rack-like configuration).

It is to be understood that mounting holes may be arranged in the first rod 1246, the second rod 1247, the first securing rod 1251, and the second securing rod 1252. In a case where the servers 111 and the power distribution units 132 are placed in the first mounting positions 1240 or the second mounting positions 1250 respectively, fasteners such as screws or bolts may be used in conjunction with the mounting holes to secure the servers 111 or the power distribution units 132.

In the present disclosure, the first racks 124 for accommodating servers 111 and the second racks 125 for accommodating power distribution units 132 are arranged along the first horizontal direction. Consequently, a spacing between servers 111 in adjacent liquid cooling cabinets 12 is relatively large, leading to a smaller distribution density and reducing the likelihood of heat concentration. Furthermore, the first racks 124 and the second racks 125 are in communication in the first horizontal direction. This configuration increases air convection between their respective spaces, further promoting the dissipation of heat from the servers 111.

In some embodiments, third mounting positions 1254 for accommodating the network switches 112 are arranged above the first mounting positions 1240. The third mounting positions 1254 are spaced apart from the top plate 1213. Cable routing holes 1215 are arranged in the top plate 1213. A space remaining between the third mounting position 1254 and the top plate 1213 may be used for cable routing; that is, cables may pass through the cable routing holes 1215 on the top plate 1213 to enter the internal space of the liquid cooling cabinet 12. In some embodiments, the third mounting positions 1254 are spaced apart from the first mounting positions 1240, and a space remaining therebetween may be used for cable routing. In the embodiments, the network switches 112 may be arranged close to the top plate 1213.

In some embodiments, the cable routing holes 1215 are arranged in the portion of the top panel 1213 corresponding to (or above) the second rack 125.

It is to be understood that arranging the third mounting positions 1254 above the first mounting positions 1240 means that the third mounting positions 1254 are arranged above the uppermost first mounting position 1240.

In some embodiments, the third mounting positions 1254 may be formed, similar to the first mounting positions 1240, by the cooperation of support plates 1245 connected to the first rod 1246 and the second rod 1247. In some embodiments, mounting holes are arranged in the first rod 1246 and the second rod 1247, and the network switches 112 are secured above the first mounting positions 1240 via connecting members or fasteners used in conjunction with the mounting holes. In some embodiments, the support plate 1245 is provided with mounting holes, and the network switches 112 are secured to the support plate 1245 via connecting members or fasteners. In scenarios where the dimensions of the network switches 112 are smaller than the dimensions of the servers 111, it is preferred that the network switches 112 are secured in the third mounting positions 1254 via connecting members or fasteners. In this way, the network switches 112 may also be integrated into the liquid cooling cabinets 12, thereby increasing the degree of integration without adversely affecting heat dissipation.

In some embodiments, in the vertical direction, a gap is defined between adjacent first mounting positions 1240; and/or a gap is defined between adjacent second mounting positions 1250; and/or a gap is defined between the first mounting position 1240 and the third mounting position 1254. The presence of these gaps enhances air convection, further improving the heat dissipation efficiency.

In some embodiments, the liquid cooling apparatus 10 further includes a water inlet pipe 127, a water outlet pipe 128, and a liquid path control device 129 connected to the water inlet pipe 127 and/or the water outlet pipe 128 to control the flow of liquid. Via the liquid path control device 129, water is supplied through the water inlet pipe 127 into the liquid cooling cabinet 12. After the water absorbs heat, the water is discharged from the water outlet pipe 128 and then either discarded, or is cooled and then resupplied to the water inlet pipe 127.

The liquid cooling cabinet 12, in the second horizontal direction, includes a first side 12a and a second side 12b that are opposite to each other. On the first side 12a, the liquid cooling cabinet 12 includes a first manifold 122a arranged close to the first rack body 1241 and a second manifold 122b arranged close to the second rack body 1242. The water inlet pipe 127 is in communication with the first manifold 122a, and the water outlet pipe 128 is in communication with the second manifold 122b. The first manifold 122a is connected to the liquid inlet connectors on the servers 111, and the second manifold 122b is connected to the liquid outlet connectors on the servers 111. After water enters through the water inlet pipe 127, the water flows into the first manifold 122a, and then flows through the liquid inlet connectors into the liquid cooling plates (or cold plates) of the servers 111. After the water absorbs the heat generated by the operation of the servers 111, the water is discharged through the liquid outlet connectors, flows into the second manifold 122b, and is then discharged from the water outlet pipe 128

In some embodiments, the liquid cooling cabinet 12, on the second side 12b, includes a cable management column 123 arranged close to the second rack body 1242. The cable management column 123, in the first horizontal direction or the second horizontal direction, includes a first part 123a and a second part 123b that are engageable with each other together. A plurality of notches are arranged in the first part 123a for cables to be inserted or routed. Cables may be accommodated within a space enclosed by the first part 123a and the second part 123b, and may pass out through the notches and connected to their respective servers 111. The cables may be power cables for power supply circuits or communication cables for communication lines.

In some embodiments, the water inlet pipe 127 and the water outlet pipe 128 of the liquid cooling cabinet 12 are connected to the liquid cooling cabinet 12 from the first side 12a, and cables from the power distribution cabinet 131 and/or cables from the network switch 112 enter the liquid cooling cabinet 12 from the second side 12b. Since the electrical circuits and the liquid paths are disposed on opposite sides of the liquid cooling cabinets 12, the electrical circuits and the liquid paths are kept distant from each other, which prevents water leakage from affecting the electrical circuits.

In some embodiments, in the first horizontal direction, the power distribution cabinet 131 is arranged at one end of the liquid cooling cabinet group, and the liquid path control device 129 is arranged at the other end of the liquid cooling cabinet group. The liquid path control device 129 and the liquid cooling cabinet group are disposed within a same space, or a separating plate 129q is disposed therebetween to separate the liquid path control device 129, the liquid cooling cabinet group, and the power distribution cabinet 131 into different spaces.

In some embodiments, the separating plate 1291 is provided with a notch 1291a to allow the water inlet pipe 127 and the water outlet pipe 128 to pass through. The separating plate 1291 separates the liquid cooling cabinet 12 and the power distribution cabinet 131 into a first space, and separates the liquid path control device 129 into a second space. Therefore, even though a fault occurs in the liquid path control device 129 causing water to flow out, it is less likely to affect the data processing system 11 and the power distribution cabinet 131. This improves the waterproof performance of the liquid cooling apparatus 10, and the safety is significantly enhanced. Furthermore, because the power distribution cabinet 131 is arranged on the side of the liquid cooling cabinet 12 away from the liquid path control device 129, and the power distribution cabinet 131 and the liquid path control device 129 are disposed at opposite ends of the liquid cooling cabinet 12 respectively, an even distribution of weight for the liquid cooling apparatus 10 is achieved, thereby facilitating lifting, transportation, and stable placement. The power distribution cabinet 131 is away from the liquid path control device 129, that is, the power distribution cabinet 131 is completely outside the water path channels. Even though leakage occurs, the likelihood that power distribution cabinet 131 is affected is significantly reduced.

In some embodiments, a separating plate 1291 with a notch 1291a may also be arranged between the power distribution cabinet 131 and the liquid cooling cabinet 12. The notch 1291a allows for the passage of cables. The separating plate 1291 separates the liquid cooling cabinet 12 from the power distribution cabinet 131, thereby further ensuring the electrical safety of the power distribution cabinet 131.

In some embodiments, a recessed portion 1291b extending in the vertical direction is arranged on the separating plate 1291. Water flowing on the separating plate 1291 may be quickly guided by the separating plate 1291 to the bottom thereof.

In some embodiments, the main bodies of the main water inlet pipe 127 and the main water outlet pipe 128 extend along the first horizontal direction and are offset from the liquid cooling cabinet 12 in the second horizontal direction. That is, a distance in the second horizontal direction is present between the main bodies of the main water inlet pipe 127 and the main water outlet pipe 128, and the liquid cooling cabinet 12. Thus, even though leakage occurs, water flow is likely to directly enter the liquid cooling cabinet 12.

In some embodiments, a cable tray A is arranged at a top end of the liquid cooling cabinet 12 that is away from the water inlet pipe 127 or the water outlet pipe 128 in the second horizontal direction. Cables from the power distribution cabinet 131 to the data processing system 11 may be placed on the cable tray A and enter the liquid cooling cabinet 12 through the cable routing holes 1215 in the top of the liquid cooling cabinet 12. Since the cable tray A is away from the water inlet pipe 127 or the water outlet pipe 128 in the second horizontal direction, its susceptibility to the effects of leakage is also significantly reduced.

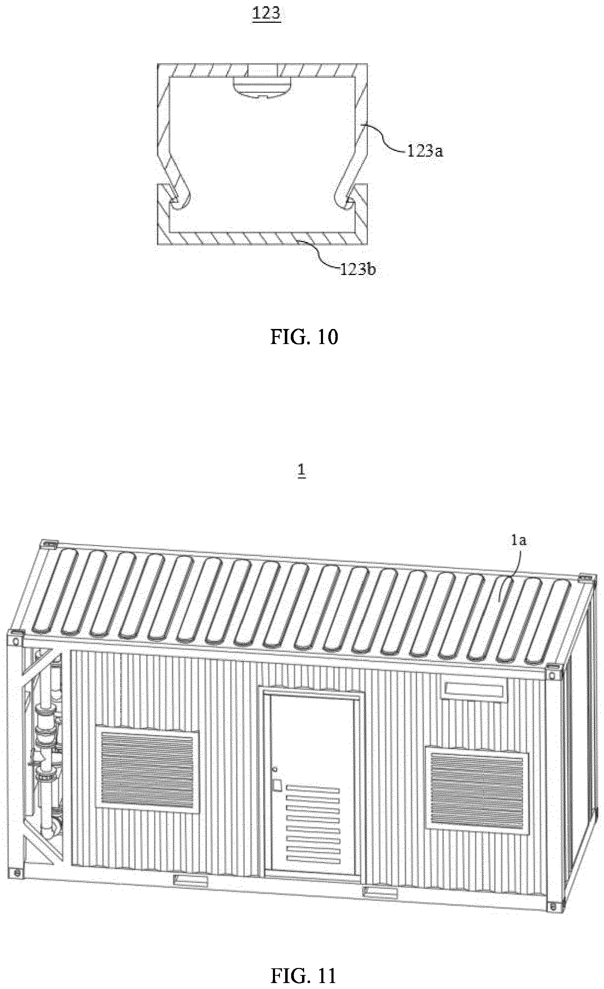

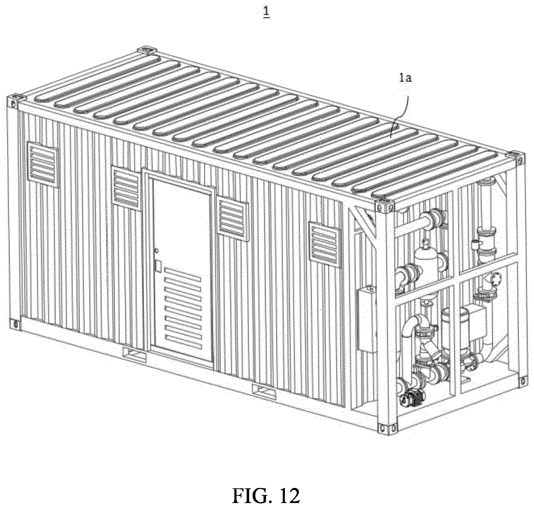

Referring to FIG. 11 and FIG. 12, some embodiments of the present disclosure further provide a liquid-cooled container 1. The liquid-cooled container 1 includes an outer shell 1a and the liquid cooling apparatus 10 as described above. The liquid cooling apparatus 10 is at least partially accommodated within the outer shell 1a.

It is to be understood that the liquid-cooled container 1 may have standard container dimensions, for example, a 20-foot standard container or high cube container, a 40-foot standard container or high cube container, or any other dimensions, which may be determined according to actual needs.

The liquid-cooled container 1 according to the present disclosure is generally rectangular (or box-shaped), which may be cube-shaped, cuboid-shaped (or rectangular parallelepiped-shaped), or substantially cube-shaped or cuboid-shaped; or may have other regular or irregular shapes.

A person skilled in the art would understand that the above technical solutions may be freely combined and superimposed as long as no conflicts exist.

It should be understood that the above embodiments are only exemplary, and construe no limitations. Under the circumstance of not departing from the basic principles of the present disclosure, various obvious or equivalent modifications or substitutions that persons skilled in the art may derive to the above-described details are all included within the scope of the claims of the present disclosure.

## Claims

1. A liquid cooling apparatus, comprising: a liquid cooling cabinet, a server, and a power distribution unit; wherein a number of series-connected chips within the server is greater than one hundred; and the liquid cooling cabinet comprises a first side panel, a top plate, a second side panel, and a base plate that are sequentially connected to form a rectangular frame, wherein the first side panel and the second side panel are arranged opposite to each other in a first horizontal direction, the top plate and the base plate are arranged opposite to each other in a vertical direction, and the rectangular frame is open in a second horizontal direction, the first horizontal direction being perpendicular to the second horizontal direction;
wherein a first rack is secured within the rectangular frame, the first rack comprising a first rack body and a second rack body, wherein the first rack body and the second rack body are arranged along the first horizontal direction, the first rack body is abutted against an inner wall of the first side panel, the second rack body is spaced apart from the second side panel, the first rack body and the second rack body cooperate to form the first rack, and a plurality of first mounting positions for accommodating the servers are arranged on the first rack in the vertical direction; and
wherein a second rack is further secured within the rectangular frame, a plurality of second mounting positions for accommodating the power distribution units being arranged on the second rack in the vertical direction; and one end of the second rack is secured to the second rack body, and another end of the second rack is abutted against an inner wall of the second side panel.

2. The liquid cooling apparatus according to claim 1, wherein a third mounting position is arranged above the first mounting position, wherein the third mounting position is spaced apart from the top plate;
the liquid cooling apparatus further comprises a network switch, wherein the network switch is accommodated in the third mounting position; and
a cable routing hole is arranged in the top plate.

3. The liquid cooling apparatus according to claim 2, wherein in the vertical direction, a spacing is defined between adjacent first mounting positions; and/or
a spacing is defined between adjacent second mounting positions; and/or
a spacing is defined between the first mounting position and the third mounting position.

4. The liquid cooling apparatus according to claim 1, wherein each of the first rack body and the second rack body comprises a main body and a plurality of support plates spaced apart along the vertical direction, the support plates being connected to the main body;
wherein the support plates on the first rack body and the support plates on the second rack body at a same height cooperate to form the first mounting position, and opposite ends of the server are configured to rest on the support plates; and
wherein the main body comprises a first rod and a second rod that extend along the vertical direction, wherein the first rod is parallel to the second rod, the first rod and the second rod are both securely connected to the rectangular frame, one end of each of the support plates is connected to the first rod, and another end of the support plate is connected to the second rod.

5. The liquid cooling apparatus according to claim 1, wherein the second rack comprises a plurality of first securing rods spaced apart along the vertical direction, a plurality of second securing rods spaced apart along the vertical direction, and at least two mutually parallel connecting rods connected between the first securing rod and the second securing rod at a same height.

6. The liquid cooling apparatus according to any one of claims 1 to 5, wherein the server comprises opposite first and second ends; wherein a power supply and/or communication interface is arranged at the first end, a liquid inlet connector and a liquid outlet connector are arranged at the second end, and a liquid flow plate in communication with both the liquid inlet connector and the liquid outlet connector is arranged inside the server;
a plurality of the liquid cooling cabinets are provided, and the liquid cooling cabinets are closely arranged along the first horizontal direction to form a liquid cooling cabinet group;
in the second horizontal direction, each of the liquid cooling cabinets comprises opposite first and second sides, and the liquid cooling cabinet, on the first side, comprises a first manifold arranged close to the first rack body and a second manifold arranged close to the second rack body, wherein the liquid inlet connector is connected to the first manifold, and the liquid outlet connector is connected to the second manifold; and
the liquid cooling apparatus further comprises an water inlet pipe and an water outlet pipe, and a liquid path control device connected to the water inlet pipe and/or the water outlet pipe to control water flow, wherein the water inlet pipe is in communication with the first manifold, and the water outlet pipe is in communication with the second manifold;
wherein the liquid path control device and the liquid cooling cabinet group are disposed within a same space, or a separating plate is disposed therebetween to separate the liquid path control device and the liquid cooling cabinet group into different spaces.

7. The liquid cooling apparatus according to claim 6, wherein a drip tray is arranged at the second end, the drip tray being disposed below the liquid inlet connector and the liquid outlet connector;
wherein the server comprises an outer shell, wherein the drip tray is integrally formed with the outer shell.

8. The liquid cooling apparatus according to claim 6, wherein a cable routing hole is arranged in the top plate corresponding to the second rack; and
the liquid cooling cabinet, on the second side, comprises a cable management column arranged close to the first rack body;
wherein the cable management column, in the first horizontal direction or the second horizontal direction, comprises a first part and a second part that are engageable with each other, a plurality of notches for cables to be inserted therein being arranged in the second part.

9. The liquid cooling apparatus according to claim 6, further comprising: a power distribution cabinet, the power distribution unit drawing power from the power distribution cabinet;
wherein in the first horizontal direction, the power distribution cabinet is arranged at one end of the liquid cooling cabinet group, and the liquid path control device is arranged at another end of the liquid cooling cabinet group.

10. A liquid-cooled container, comprising: an enclosure and the liquid cooling apparatus as defined in any one of claims 1 to 9, wherein the liquid cooling apparatus is at least partially accommodated within the enclosure.
